# EUROPEAN PATENT APPLICATION

(11) **EP 3 750 850 A1**
(43) Date of publication of application: **16.12.2020**
(21) Application number: 19751295.7
(22) Date of filing: 29.01.2019
(51) Int. Cl.: C01B 32/158, B65G 49/07, B82Y 30/00, H01L 21/677

(54) **CARBON NANOTUBE AGGREGATE**

(30) Priority: 06.02.2018 JP 2018018910
(71) Applicant: NITTO DENKO CORPORATION, Ibaraki-shi Osaka 567-8680 (JP)
(72) Inventor: MASUDA Shotaro, Ibaraki-shi, Osaka 567-8680 (JP)
(74) Representative: Müller-Boré & Partner Patentanwälte PartG mbB
(86) International application number: PCT/JP2019/003036
(87) International publication number: WO 2019/155947

(57) **Abstract**

The present invention has an object to provide a carbon nanotube aggregate exhibiting excellent grip force in room temperature and high temperature environments. The present invention relates to a carbon nanotube aggregate comprising a plurality of carbon nanotubes aggregated in a sheet form, wherein a degree of orientation in a middle part is less than 84%, and a degree of orientation in at least one surface part is 15% or more.

## Description

### TECHNICAL FIELD

The present invention relates to a carbon nanotube aggregate.

### BACKGROUND ART

In transporting an object to be processed such as a material, a production intermediate or a product in a manufacturing process of a semiconductor device or the like, the object to be processed is transported using a carrying member such as movable arm or a movable table (see, for example, Patent Literatures 1 and 2). In carrying out such transportation, strong grip force so as to prevent the object to be processed from sifting during transporting is demanded for a member on which the object to be process is mounted (fixing jig for transportation). In addition, such demand has increased year by year coupled with a demand for faster manufacturing process.

However, the conventional fixing jig holds the object to be processed by an elastic material such as a resin and has the problem that the elastic material is easy to adhere to and remains in the object to be processed. Additionally, the elastic material such as a resin has low heat resistance and therefore has the problem that its grip force is reduced in high temperature environment.

When a material such as ceramics is used in the fixing jig for transportation, contamination of the object to be processed is prevented, and the temperature dependency of grip force is reduced. However, a fixing jig for transportation formed of such a material involves the problem that grip force is inherently weak and the object to be processed cannot be sufficiently held even at normal temperature.

A method of holding the object to be processed in high temperature environment includes a method of vacuum sucking the object to be processed, and a method of fixing the object to be processed by the shape of a fixing jig for transportation (for example, chucking or counterbore fixing). However, the method of vacuum sucking is effective only in the air atmosphere, and cannot be used under vacuum in CVD process or the like. Furthermore, the method of fixing the object to be processed by the shape of the fixing jig for transportation has the problems such that the object to be processed is damaged by the contact between the objected to be processed and the fixing jig for transportation, and particles are generated.

### CITATION LIST

### PATENT LITERATURE

Patent Literature 1: JP-A-2001-351961
Patent Literature 2: JP-A-2013-138152

### SUMMARY OF INVENTION

### TECHNICAL PROBLEM

An adhesive structure having a carbon nanotube aggregate is considered to use as a means for solving the above problems. The carbon nanotube aggregate can be generally obtained by forming a catalyst layer on a predetermined substrate, filling a carbon source in the state that the catalyst has been activated by heat, plasma or the like, and growing the carbon nanotubes (chemical vapor deposition). According to the production method, a carbon nanotube aggregate constituted of carbon nanotubes almost vertically oriented from a substrate is obtained.

However, as a result of extensive and intensive investigations on the application of a carbon nanotube aggregate to a fixing jig for transportation, the present inventors have found the problem that grip force between the carbon nanotube aggregate and a member to be held is rapidly reduced particularly in high temperature environment. Therefore, a carbon nanotube aggregate exhibiting sufficient grip force even in high temperature environment, for example, 300°C is desired.

The present invention has been completed in view of the above, and an object thereof is to provide a carbon nanotube aggregate exhibiting excellent grip force in room temperature and high temperature environments.

### SOLUTION TO PROBLEM

As a result of further extensive and intensive investigations, the present inventors have found that the above problems can be solved by controlling the degree of orientation in a carbon nanotube aggregate.

Specifically, the carbon nanotube aggregate of the present invention is a carbon nanotube aggregate comprising a plurality of carbon nanotubes aggregated in a sheet form, wherein a degree of orientation in a middle part is less than 84%, and a degree of orientation in at least one surface part is 15% or more.

In one embodiment of the carbon nanotube aggregate of the present invention, the degree of orientation in at least one surface part may be less than 50%.

One embodiment of the carbon nanotube aggregate of the present invention may have a thickness of 300 to 2000 µm.

In one embodiment of the carbon nanotube aggregate of the present invention, at least one surface thereof may have a maximum static friction coefficient at 23°C with respect to a silicon wafer of 4 or more.

In one embodiment of the carbon nanotube aggregate of the present invention, a density in at least one surface part may be 45 or less.

In one embodiment of the carbon nanotube aggregate of the present invention, at least one surface thereof may have a contact angle with respect to water of 100° or more.

The fixing jig for transportation of the present invention includes the carbon nanotube aggregate of the present invention.

### ADVANTAGEOUS EFFECTS OF INVENTION

The carbon nanotube aggregate of the present invention exhibits excellent grip force in room temperature and high temperature environments.

### BRIEF DESCRIPTION OF DRAWINGS

FIG. 1 is a schematic sectional view of a carbon nanotube aggregate according to one embodiment of the present invention.
FIG. 2 is a schematic sectional view of an apparatus for producing a carbon nanotube aggregate according to one embodiment of the present invention.
FIG. 3 is an SEM image of a middle part of a carbon nanotube aggregate according to one embodiment of the present invention.
FIG. 4 is an SEM image of a surface part of a carbon nanotube aggregate according to one embodiment of the present invention.

### DESCRIPTION OF EMBODIMENTS

The embodiments for carrying out the present invention are described in detail below. However, the present invention is not construed as being limited to the embodiments described below.

### [Carbon nanotube aggregate]

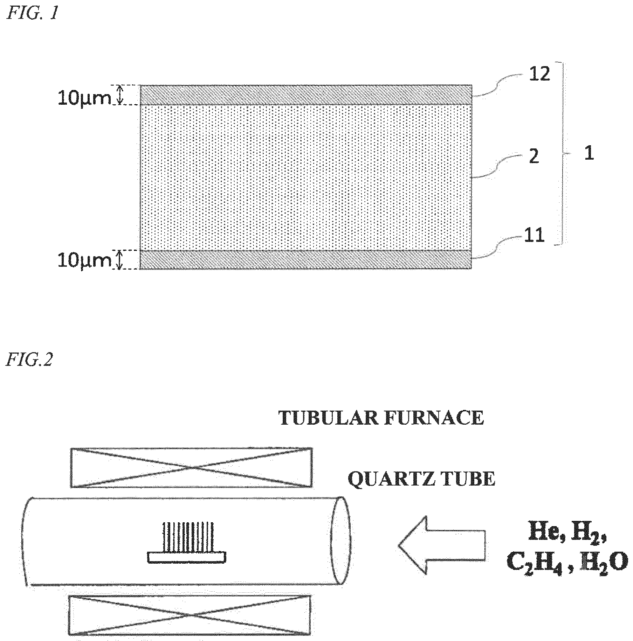

FIG. 1 is a schematic sectional view schematically showing a part of a carbon nanotube aggregate of the present embodiment. The carbon nanotube aggregate includes a plurality of carbon nanotubes formed in a sheet form.

A carbon nanotube aggregate 1 of the present embodiment has two surface parts (edges) 11 and 12 and a middle part 2 between those surface parts, in its thickness direction (length direction of carbon nanotubes).

The surface part used herein means an area up to 10 µm in a thickness direction from the outermost surface of the carbon nanotube aggregate 1.

Furthermore, the degree of orientation means a ratio of the total length of the portions having an angle to a surface direction of a sheet-shaped carbon nanotube aggregate (a direction vertical to a thickness direction of the carbon nanotube aggregate) of 70 to 110° (hereafter referred to as "near-vertical") to the overall length of the carbon nanotubes. Specifically, the degree of orientation can be measured by the method described in the column of Examples.

In other words, high degree of orientation of a sheet-shaped carbon nanotube aggregate means that there are a lot of portions vertical to a surface direction of a sheet in carbon nanotubes constituting a carbon nanotube aggregate.

In the carbon nanotube aggregate of the present embodiment, the degree of orientation in the middle part is less than 84%, and the degree of orientation in at least one surface part is 15% or more. Such a carbon nanotube aggregate has excellent grip force in room temperature and high temperature environments for the reasons described below.

Grip force generated between the carbon nanotube aggregate and a member to be held is due to Van der Waals force generated between each carbon nanotube constituting the carbon nanotube aggregate and a member to be held. The magnitude of Van der Waals force generated between the carbon nanotubes and the member to be held is inverse proportion to the 6th power of those distances. Therefore, in the case where those are not in contact with each other, the magnitude is remarkably decreased. In other words, the grip force of the carbon nanotube aggregate can be increased by increasing the number of carbon nanotubes in contact with the member to be held.

The carbon nanotubes constituting the carbon nanotube aggregate have delicate variations in length, and additionally, delicate unevenness is present on the surface of the member to be held. Furthermore, the carbon nanotubes are rigid and therefore have poor stretchability in a length direction. Therefore, in the case where the carbon nanotube aggregate having high degree of orientation in the middle part is brought into contact with the member to be held, a part of the carbon nanotubes can only come in contact with the member to be held, leading to poor grip force.

On the other hand, according to the carbon nanotube aggregate of the present embodiment having low degree of orientation of less than 84% in the middle part occupying the most portion of the carbon nanotube aggregate, the individual carbon nanotubes are rich in stretchability in a thickness direction of the carbon nanotube aggregate. As a result, in the case where the carbon nanotube aggregate of the present embodiment is brought into contact with the member to be held, the proportion of carbon nanotubes that are not in contact with the member to be held can be reduced, thereby exhibiting high grip force.

From the above standpoints, in the carbon nanotube aggregate of the present embodiment, the degree of orientation in the middle part is less than 84%, preferably less than 82%, more preferably less than 80% and still more preferably less than 74%.

In the carbon nanotube aggregate of the present embodiment, the lower limit of the degree of orientation in the middle part is not particularly limited, but is generally, for example, 15% or more and preferably 20% or more.

When the degree of orientation of the surface part in the side contacting the member to be held is less than 15%, stretchability in a thickness direction of the tip of individual carbon nanotubes is rather decreased, and the number of carbon nanotubes contacting the member to be held is decreased, leading to the deterioration of grip force.

Therefore, in the carbon nanotube aggregate of the present embodiment, the degree of orientation in at least one surface part is 15% or more. The degree of orientation in at least one surface part is preferably 20% or more and more preferably 25% or more.

In the carbon nanotube aggregate of the present embodiment, the upper limit of the degree of orientation of the surface part is not particularly limited. However, low degree of orientation of the surface part in the side contacting the member to be held improves grip force so long as the above-described deterioration of grip force does not occur, and this is preferred. Specifically, the degree of orientation in at least one surface part is preferably less than 50%, more preferably less than 40% and still more preferably 30%.

In the present embodiment, in the case where the degree of orientation of at least one surface part of the carbon nanotube aggregate is in the range described above, the degree of orientation in the surface part of the substrate side is preferably in the range described above in the production process of the carbon nanotube aggregate described hereinafter. In the present embodiment, the degree of orientation of both surface parts of the carbon nanotube aggregate may be in the range described above.

The carbon nanotube aggregate of the present embodiment exhibiting excellent grip force as a result that the degree of orientation in the middle part and at least one surface part was controlled as described above can exhibit practically sufficient grip force even in the case where grip force has been decreased in high temperature environment.

Furthermore, the carbon nanotube aggregate of the present embodiment has low degree or orientation in at least the middle part. Therefore, the connection in a surface direction of each carbon nanotube constituting the carbon nanotube aggregate is enhanced. As a result, in the carbon nanotube aggregate of the present embodiment, each carbon nanotube is difficult to be scattered and a sheet form can be maintained.

The thickness of the carbon nanotube aggregate of the present embodiment is not particularly limited, but is, for example, 10 µm to 5000 µm, preferably 50 µm to 4000 µm, more preferably 100 µm to 3000 µm and still more preferably 300 µm to 2000 µm. The thickness of the carbon nanotube aggregate is an average value of, for example, three points randomly extracted in the inside of 0.2 mm or more from the edge in a surface direction of the carbon nanotube aggregate layer.

Particularly, in using the carbon nanotube aggregate in the uses requiring grip force, such as a fixing jig for transportation, the thickness of the carbon nanotube aggregate is preferably 300 µm to 2000 µm and more preferably 500 µm to 1500 µm.

The grip becomes excellent as the maximum static friction coefficient of the surface of the carbon nanotube aggregate becomes large. Specifically, for example, the maximum static friction coefficient at 23°C with respect to the silicon wafer surface measured by the method described in the column of Examples is preferably 6 or more, more preferably 20 or more and still more preferably 50 or more. In addition, the maximum static friction coefficient of the carbon nanotube aggregate is preferably large even at high temperature in order to exhibit sufficient grip force even in high temperature environment. Specifically, for example, the maximum static friction coefficient at 300°C with respect to the silicon wafer surface measured by the method described in the column of Examples is preferably 0.3 or more, more preferably 0.7 or more and still more preferably 1.0 or more.

Needless to say, the carbon nanotube aggregate having large friction coefficient with respect to the silicon wafer surface can also exhibit strong grip with respect to a member (for example, glass) constituted of a material other than silicon.

The density of the carbon nanotube aggregate of the present embodiment is not particularly limited. However, when the density in the middle part is decreased, individual carbon nanotubes becomes easy to stretch and as a result, grip force is improved. Therefore, the carbon nanotube aggregate of the present embodiment preferably has low density in the middle part. Specifically, for example, the density in the middle part measured by the following method is preferably 46% or less, more preferably 45% or less and still more preferably 44% or less.

When the density is decreased in the surface part, individual carbon nanotubes become difficult to aggregate, and the proportion of the carbon nanotubes that are not in contact with the member to be held can be decreased. As a result, grip force is improved. Therefore, the carbon nanotube aggregate of the present embodiment preferably has low density in at least one surface part. Specifically, for example, the density in at least one surface part measured by the following method is preferably 46% or less, more preferably 44% or less and still more preferably 42% or less.

### (Measurement method of density)

Cross section obtained by vertically cutting the carbon nanotube aggregate in a surface direction was observed using a scanning electron microscope (SEM), and a cross section with 20000 magnifications of 2×3 µm area was obtained. The cross section obtained was subjected to an image processing in the following procedures using WinROOF 2015 (manufactured by Mitani Corporation), and a density was calculated.
1. Removal of background, size of object: 0.248 µm
2. Filter>median, filter size: 3^{∗}3
3. Lookup table conversion (histogram average brightness correction), correction reference value: 90
4. Binarization by single threshold, threshold: 96, transparency: 53
5. Morphology>closing, number: 1
6. Total area·number>area ratio

The area ratio is regarded as a density of the carbon nanotube.

The tip of the individual carbon nanotubes in the surface of the carbon nanotube aggregate of the present embodiment is preferably not parallel (that is, tilted state) to the surface direction of the carbon nanotube aggregate. When the individual carbon nanotubes are in a tilted state, the tip of the individual carbon nanotubes becomes difficult to contact with the member to be held, and there is a possibility that grip force is reduced.

Property having the correlation with a direction to which the tip of the individual carbon nanotubes in the surface of the carbon nanotube aggregate faces includes water repellency of the carbon nanotube aggregate. The water repellency of the carbon nanotube aggregate is improved as the proportion that the tip of the individual carbon nanotubes in the surface of the carbon nanotube aggregate is straight (that is, vertical in the surface direction of the carbon nanotube aggregate) is high. On the other hand, the water repellency of the carbon nanotube aggregate is decreased as the proportion of the tip in a tilted state is high, and water becomes easy to penetrate inside the carbon nanotube aggregate.

From the above, in the carbon nanotube aggregate of the present embodiment, it is preferable that at least one surface has excellent water repellency. More specifically, a contact angle to water of at least one surface is preferably 80° or more, more preferably 100° or more and still more preferably 120° or more. The contact angle to water can be measured according to JIS R3257:1999.

The carbon nanotube aggregate of the present embodiment can be applied to, for example, a fixing jig for transportation. The fixing jig for transportation can be suitably used in, for example, a manufacturing process of a semiconductor element, a manufacturing process of an optical member, and the like. In more detail, the fixing jig for transportation can be used to transport a material, an intermediate product, a product and the like (specifically, a semiconductor material, a wafer, a chip, a substrate, a ceramic plate and a film) between a step and a step or in a given process, in the manufacturing of a semiconductor element. The fixing jig for transportation can further be used to transport a glass substrate or the like between a step and a step or in a given process, in the manufacturing of an optical member. Other than the above, the fixing jig for transportation can be suitably used in uses requiring grip force, and can be further used in, for example, robot hand.

### <Carbon nanotubes>

A shape, a diameter, the number of layers, and the like of the carbon nanotubes constituting the carbon nanotube aggregate of the present embodiment can be measured by the conventional methods, for example, by a scanning electron microscope (SEM) or a transmission electron microscope (TEM). For example, 10 or more or preferably 20 or more carbon nanotubes are taken out of the carbon nanotube aggregate and observed with SEM or TEM, and the shape, the diameter and, the number of layers can be measured.

Examples of the shape, the diameter and the number of layers are shown below, but those are not particularly limited in the carbon nanotubes in the present embodiment.

The shape of the carbon nanotubes constituting the carbon nanotube aggregate of the present embodiment is not particularly limited so long as it has any appropriate shape. Examples of the shape of its cross section includes almost circle, ellipse and n-sided polygon (n is an integer of 3 or more).

The diameter of the carbon nanotubes constituting the carbon nanotube aggregate of the present embodiment is preferably 3 nm to 20 nm, more preferably 6 nm to 15 nm and still more preferably 7 nm to 9 nm. The carbon nanotube aggregate having excellent grip force to the member to be held can be obtained by adjusting the diameter of the carbon nanotubes to fall within the above range.

The number of layers of the carbon nanotubes constituting the carbon nanotube aggregate of the present embodiment is preferably 1 to 10 layers, more preferably 2 to 7 layers and still more preferably 3 to 4 layers.

The specific surface area and density of the carbon nanotubes constituting the carbon nanotube aggregate of the present embodiment can be set to any appropriate values.

### [Method of producing carbon nanotube aggregate]

The method of producing the carbon nanotube aggregate of the present embodiment is not particularly limited. The carbon nanotube aggregate can be produced by, for example, chemical vapor deposition (CVD) including forming a catalyst layer on a substrate, atomizing the catalyst layer, supplying a carbon source in the state that the catalyst has been activated by heat, plasma or the like. The details are described below.

Any appropriate substrate can be used as the substrate that can be used in the method of producing the carbon nanotube aggregate. For example, a material having smoothness and high temperature heat resistance that can withstand the production of carbon nanotubes is used. Examples of the material include a metal oxide such as quartz glass, zirconia or alumina, silicon (silicon wafer or the like), a metal such as aluminum or copper, a carbide such as silicon carbide, and a nitride such as silicon nitride, aluminum nitride or gallium nitride.

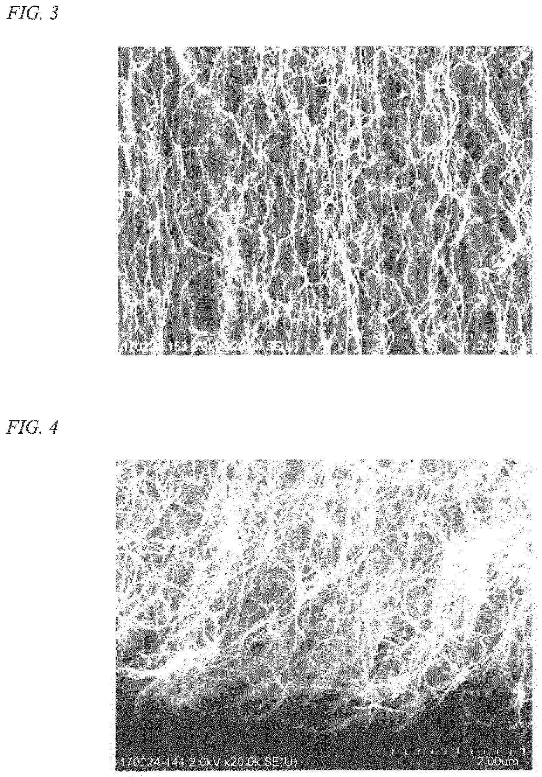

Any appropriate apparatus can be used as an apparatus for producing the carbon nanotube aggregate. For example, a thermal CVD apparatus includes a hot wall type constituted by surrounding a cylindrical reaction vessel with a resistance heating type electric tubular furnace as shown in FIG. 3. In this case, for example, a heat-resistant quartz tube is preferably used as the reaction vessel.

An intermediate layer is preferably provided between the substrate and the catalyst layer. A material constituting the intermediate layer includes a metal and a metal oxide. Of those, a metal oxide is preferred, and the intermediate layer is particularly preferably constituted of alumina.

The catalyst layer is a layer including a catalyst, provided on the intermediate layer or the substrate. Any appropriate catalyst can be used as a material of the catalyst layer. Examples of the catalyst include metal catalysts such as iron, cobalt, nickel, gold, platinum, silver and copper, and of those, iron is particularly preferred.

The amount of the catalyst layer is preferably 50 ng/cm² to 2000 ng/cm², more preferably 100 ng/cm² to 1000 nm/cm² and particularly preferably 200 ng/cm² to 500 ng/cm², in order to control the number density of catalyst atomized described hereinafter to an appropriate range.

As a method of forming the catalyst layer, any appropriate method may be used. For example, there may be mentioned a method of depositing the metal catalyst by EB (electron beams), sputtering or the like, and a method of applying a suspension of metal catalyst fine particles to the substrate.

The catalyst layer formed by the above method is atomized by a treatment such as heating and can be used in the production of the carbon nanotube aggregate. In this case, when the number density of the catalyst atomized on the intermediate layer or the substrate is too large, each carbon nanotube interferes with the adjacent carbon nanotube aggregate, and becomes easy to grow almost vertically. This makes it difficult to decrease the degrees of orientation in the middle part and surface part of the carbon nanotube aggregate. On the other hand, when the number density of the catalyst atomized on the intermediate layer or the substrate is too small, the catalyst layer becomes difficult to handle as a sheet form. From the above standpoints, the number density of the catalyst atomized on the intermediate layer or the substrate is preferably 200 numbers/µm² or more, more preferably 300 numbers/µm² or more and still more preferably 400 numbers/µm² or more. On the other hand, the number density is preferably 1000 numbers/µm² or less, more preferably 750 numbers/µm² or less and still more preferably 500 numbers/µm² or less.

The number density of the catalyst atomized on the intermediate layer or the substrate can be controlled by controlling the amount of the catalyst layer, and the heating temperature and heating time in atomizing. To make the number density to fall within the above appropriate range, the heating temperature in atomizing the catalyst is preferably 790°C or higher, more preferably 815°C or higher and still more preferably 840°C or higher. On the other hand, the heating temperature is preferably 940°C or lower, more preferably 915°C or lower and still more preferably 890°C or lower.

The heating time in atomizing the catalyst is preferably 15 minutes or more, more preferably 30 minutes or more and still more preferably 60 minutes or more. On the other hand, the heating time is preferably 180 minutes or less, more preferably 150 minutes or less and still more preferably 120 minutes or less.

The size of the catalyst fine particles formed by the method such as heating treatment as described above is that an average particle diameter of an equivalent circle diameter is preferably 4 nm or more, more preferably 8 nm or more and still more preferably 12 nm or more. On the other hand, the average particle diameter is preferably 44 nm or less, more preferably 33 nm or less and still more preferably 18 nm or less.

Subsequently, a carbon source is supplied in the state that the catalyst atomized by the above method has been activated by heat, plasma or the like, thereby growing the carbon nanotubes.

Any appropriate carbon source can be used as a carbon source that can be used in the production of the carbon nanotube aggregate. The degree of orientation can be controlled depending on the kind of the carbon source used. For example, hydrocarbons such as methane, ethylene, acetylene or benzene, and alcohols such as methanol or ethanol can be used. Of those, ethylene is particularly preferably used.

The carbon source is supplied as a mixed gas together with helium, hydrogen and water vapor. The degree of orientation of the carbon nanotube produced can be controlled by controlling the composition of the gas. In particular, the carbon nanotube aggregate having appropriate degree of orientation can be obtained by controlling the concentration of hydrogen and water vapor and appropriately controlling a redox state of the catalyst fine particles.

From the above standpoints, the concentration at 23°C of the carbon source (preferably ethylene) in the mixed gas is preferably 1 vol% or more, more preferably 3 vol% or more and still more preferably 5 vol% or more. On the other hand, the concentration is preferably 30 vol% or less, more preferably 20 vol% or less and still more preferably 10 vol% or less.

The concentration at 23°C of the hydrogen in the mixed gas is preferably 40 vol% or more, more preferably 50 vol% or more and still more preferably 60 vol% or more. On the other hand, the concentration is preferably 85 vol% or less, more preferably 80 vol% or less and still more preferably 75 vol% or less.

The concentration at 23°C of the water vapor in the mixed gas is preferably 0.005 vol% or more, more preferably 0.01 vol% or more and still more preferably 0.02 vol% or more. On the other hand, the concentration is preferably 0.3 vol% or less, more preferably 0.2 vol% or less and still more preferably 0.1 vol% or less.

The remainder of the mixed gas is preferably an inert gas. For example, helium or nitrogen is preferred. When the mixed gas having the above composition is used, the carbon nanotube aggregate having appropriate degree of orientation can be obtained.

In the mixed gas, a volume ratio (hydrogen/carbon source) between the carbon source (preferably ethylene) and the hydrogen is preferably 3 or more and more preferably 8 or more. On the other hand, the volume ratio is preferably 40 or less and more preferably 12 or less. When the volume ratio is in such a range, the carbon nanotube aggregate having appropriate degree of orientation can be obtained.

In the mixed gas, a volume ratio (hydrogen/water vapor) between the hydrogen and the water vapor is preferably 280 or more and more preferably 750 or more. On the other hand, the volume ratio is preferably 8000 or less and more preferably 3000 or less. When the volume ratio is in such a range, the carbon nanotube aggregate having appropriate degree of orientation can be obtained.

The catalyst can be activated by plasma or heat, and is preferably activated by heat. Specifically, when the temperature of the catalyst is, for example, 690°C to 840°C, preferably 715°C to 815°C and more preferably 740°C to 790°C, the catalyst can be activated.

Thus, the carbon nanotubes can be grown by suppling the mixed gas in the state that the catalyst was activated.

The carbon nanotube aggregate of the present embodiment is obtained by forming the carbon nanotube aggregate on the substrate and then collecting the carbon nanotube aggregate from the substrate as described above. The collection method is not particularly limited. For example, the carbon nanotube aggregate can be collected by tweezers.

Uses of the carbon nanotube aggregate of the present embodiment are not particularly limited, and for example, the carbon nanotube aggregate can be suitably used as a grip material in an adhesive transporting member in a transportation apparatus or a robot hand.

### Examples

The present invention is described below on the basis of Examples, but the invention is not construed as being limited to those.

### [Production of carbon nanotube aggregate]

Carbon nanotube (CNT) aggregates of Examples 1 to 4 and Comparative Examples 1 to 5 were produced by the following methods.

### <Example 1>

### (Intermediate layer and catalyst layer formation process)

Al₂O₃ thin film of 3922 ng/cm² was formed on a silicon wafer substrate (manufactured by VALQUA FFT INC., thickness: 725 µm) by a sputtering apparatus (trade name "CFS-4ES" manufactured by Shibaura Mechatronics Corporation) (ultimate vacuum: 8.0×10⁻⁴ Pa, sputtering gas: Ar, gas pressure 0.50 Pa, growth rate: 18 ng/sec). Fe thin film of 260 ng/cm² was further formed as a catalyst layer on the Al₂O₃ thin film by a sputtering apparatus (trade name "CFS-4ES" manufactured by Shibaura Mechatronics Corporation) (sputtering gas: Ar, gas pressure 0.75 Pa, growth rate: 5.5 ng/sec).

### (Catalyst atomization process)

The substrate was placed in a quartz tube having a diameter of 30 mm, He/H₂ (65/120 sccm) mixed gas keeping a moisture content of 1000 ppm was flown in the quartz tube, and the temperature in the tube was increased to 865°C over 45 minutes using an electric tubular furnace while substituting the inside of the tube.

Thereafter, the inside of the tube was stabilized at 865°C while flowing the mixed gas, the state was maintained for 120 minutes, and Fe catalyst was atomized. The density of Fe fine particles obtained was shown in Table 1. The temperature in the tube was decreased to 765°C over 10 minutes while flowing the mixed gas.

### (Carbon nanotube growth process)

H₂/H₂O/C₂H₄/He (65 vol%/0.10 vol%/8 vol%/remainder) mixed gas (raw material gas) was flown in the quartz tube in the total flow rate of 185 sccm while keeping the temperature at 765°C, and carbon nanotubes were grown by maintaining the state for 60 minutes while substituting the inside of the tube.

Thereafter, the raw material gas was stopped, and the temperature was cooled to room temperature while flowing a helium gas (40 sccm) in the tube.

Carbon nanotube aggregate of Example 1 was obtained by the above operations.

The carbon nanotube aggregate could be peeled in a sheet form from the silicon substrate using tweezers.

### <Example 2>

Carbon nanotube aggregate of Example 2 was obtained in the same manner as in Example 1, except that the time for stabilizing at 865°C in the catalyst atomization process was changed to 30 minutes.

### <Example 3>

Carbon nanotube aggregate of Example 3 was obtained in the same manner as in Example 2, except that the amount of the Fe thin film formed was changed to 550 ng/cm² in the intermediate layer and catalyst layer formation process.

### <Example 4>

Carbon nanotube aggregate of Example 4 was obtained in the same manner as in Example 3, except that the catalyst atomization process and the carbon nanotube growth process were changed as follows.

### (Catalyst atomization process)

The substrate was placed in a quartz tube having a diameter of 30 mm, He/H₂ (65/120 sccm) mixed gas keeping a moisture content of 1000 ppm was flown in the quartz tube, and the temperature in the tube was increased to 765°C over 35 minutes using an electric tubular furnace while substituting the inside of the tube.

Thereafter, the inside of the tube was stabilized at 765°C while flowing the mixed gas, the state was maintained for 30 minutes, and Fe catalyst was atomized. The density of Fe fine particles obtained was shown in Table 1.

### (Carbon nanotube growth process)

The carbon nanotube growth process was carried out in the same manner as in Example 3, except that the mixing gas used was changed to H₂/H₂O/C₂H₄/He (22 vol%/0.10 vol%/8 vol%/remainder) mixed gas.

### <Comparative Example 1>

### (Intermediate layer and catalyst layer formation process)

Al₂O₃ thin film of 3922 ng/cm² was formed on a silicon wafer substrate (manufactured by VALQUA FFT INC., thickness: 725 µm) by a sputtering apparatus (trade name "CFS-4ES" manufactured by Shibaura Mechatronics Corporation) (ultimate vacuum: 8.0×10⁻⁴ Pa, sputtering gas: Ar, gas pressure 0.50 Pa, growth rate: 18 ng/sec). Fe thin film of 550 ng/cm² was further formed as a catalyst layer on the Al₂O₃ thin film by a sputtering apparatus (trade name "CFS-4ES" manufactured by Shibaura Mechatronics Corporation) (sputtering gas: Ar, gas pressure 0.75 Pa, growth rate: 5.5 ng/sec).

### (Carbon nanotube growth process)

The substrate was placed in a quartz tube having a diameter of 30 mm, He/H₂ (105/80 sccm) mixed gas keeping a moisture content of 1000 ppm was flown in the quartz tube, and the temperature in the tube was increased to 765°C over 35 minutes using an electric tubular furnace while substituting the inside of the tube.

Thereafter, H₂/H₂O/C₂H₄/He (43 vol%/0.08 vol%/8 vol%/remainder) mixed gas (raw material gas) was flown in the quartz tube in the total flow rate of 185 sccm while keeping the temperature at 765°C, and carbon nanotubes were grown by maintaining the state for 60 minutes while substituting the inside of the tube.

Thereafter, the raw material gas was stopped, and the temperature was cooled to room temperature while flowing a helium gas (40 sccm) in the tube.

Carbon nanotube aggregate of Comparative Example 1 was obtained by the above operations.

The carbon nanotube aggregate could be peeled in a sheet form from the silicon substrate using tweezers.

### <Comparative Example 2>

Carbon nanotube aggregate of Comparative Example 2 was obtained in the same manner as in Comparative Example 1, except that the mixing gas was changed to H₂/H₂O/C₂H₄/He (43 vol%/0.03 vol%/8 vol%/remainder) mixed gas in the carbon nanotube growth process.

### <Comparative Example 3>

Carbon nanotube aggregate of Comparative Example 3 was obtained in the same manner as in Comparative Example 1, except that the mixing gas was changed to H₂/H₂O/C₂H₄/He (32 vol%/0.10 vol%/8 vol%/remainder) mixed gas in the carbon nanotube growth process.

### <Comparative Example 4>

Carbon nanotube aggregate of Comparative Example 4 was obtained in the same manner as in Comparative Example 1, except that the mixing gas was changed to H₂/H₂O/C₂H₄/He (65 vol%/0.10 vol%/19 vol%/remainder) mixed gas in the carbon nanotube growth process.

### <Comparative Example 5>

Carbon nanotube aggregate obtained in the same manner as in Example 3 was pressed in a thickness direction using a silicon wafer substrate so as to be parallel, and compressed such that the thickness became 0.2 mm. Thus, the carbon nanotube aggregate of Comparative Example 5 was obtained.

An outline of each process in the production of the carbon nanotube aggregates of Examples 1 to 4 and Comparative Examples 1 to 5 is shown in Table 1. In addition, an outline of each process in the production of the carbon nanotube aggregates of Examples 1 to 4 and Comparative Example 5 is shown in Table 2. The density of Fe fine particles in the catalyst atomization process was obtained by observing the substrate after the catalyst atomization process with SEM.

Furthermore, in each of the carbon nanotube aggregates of Examples 1 to 4 and Comparative Examples 1 to 5, the thickness, the degree of orientation in the middle part, the degree of orientation in the surface part, and grip force at 23°C and 300°C were measured by the following methods. Those results are shown in Tables 1 and 2. Regarding the carbon nanotube aggregates of Examples 1 to 4 and Comparative Example 5, a contact angle to water was measured by the following method. The results are shown in Table 2.

### (Thickness of carbon nanotube aggregate)

The carbon nanotube aggregates produced were observed with SEM from a side direction, and an average value of 5 points was used as a thickness.

### (Degree of orientation)

A cross section obtained by vertically cutting the carbon nanotube aggregate in a surface direction was observed using a scanning electron microscope (SEM), and a cross-sectional view with 20,000 magnifications of an area of 4x6 µm was obtained. The cross-sectional view obtained was subjected to image processing using a needle partial measurement function of WinROOF 2015 (manufactured by Mitani Corporation) by the following procedures, and length, width and direction of needle particles were calculated.
1. Background removal, size of object: 0.248 µm
2. Filter>median, filter size: 3^{∗}3
3. Lookup table conversion (histogram average brightness correction), correction reference value: 90
4. Binarization by single threshold, threshold: 90, transparency: 53
5. Morphology>closing, number: 1
6: Needle partial measurement, minimum length of measurement: 0.49630 µm, maximum measurement width: 0.4963 µm

The direction calculated was separated every 10°, and the total length of the needle particle every separation was obtained, and a ratio of the total length of needle particles of 70° to 110° to the total length of the whole needle particles (total length of 70° to 110° needle particles/total length of whole needle particles) was regarded as the degree of orientation.

A cross-sectional view obtained by measuring around the position of 2 µm from the surface that was the substrate side in the production process was used for the measurement of the degree of orientation of the surface part, and a cross-sectional view obtained by measuring around the middle position in the thickness direction was used for the measurement of the degree of orientation of the middle part.

The results are shown in Table 1. Regarding Example 3, SEM image of the middle part obtained is shown in FIG. 3 and SEM image of the surface part is shown in FIG. 4.

### (Maximum static friction coefficient at 23°C)

The maximum static friction coefficient was measured using the surface that was the surface in the substrate side in the production process as a measurement surface. The carbon nanotube aggregate having a size of 9×9 mm of each example and comparative example was adhered to a glass plate using an adhesive such that the surface opposite the measurement surface faces the glass plate, so as to form an equilateral triangle at intervals of 10 cm, and this was used as an evaluation sample.

Silicon wafer having a weight of 128 g was placed on the evaluation sample maintained horizontally, thereby forming the state that weight was uniformly applied to three points. Thereafter, the evaluation sample was inclined, the inclination angle was gradually increased, the maximum value of the inclination angle held by the evaluation sample without slipping off a silicon wafer was measured, and this was regarded as a critical slip angle (θ). The maximum static friction coefficient (µ) was calculated from the critical slip angle according to µ = tan θ.

The measurement limit of the maximum static friction coefficient in this method is 57 (θ = 89°), and the maximum static friction coefficient was more than the measurement limit in Examples 1 and 2.

### (Evaluation of grip force at 300°C)

Samples were similarly provided in the state that each angle of 45°, 35° and 17° was previously given.

The temperature was increased to 300°C in this state, the temperature was maintained for 30 minutes, and the grip force at 300°C was evaluated by the following criteria.
A (Very excellent): Silicon wafer was not slip off in all samples.
B (Excellent): Silicon wafer was slip off in only the sample of 45°, but was not slip off in the samples of 35° and 17°
C (Slightly excellent): Silicon wafer was slip off in the samples of 45° and 35°, but was not slip off in the sample of 17°.
D (Poor): Silicon wafer was slip off in all the samples.

### (Contact angle to water)

Contact angle to water was measured according to JIS R3257:1999 using a contact angle meter DMo-501 (manufactured by Kyowa Interface Science, Inc.) such that the surface in the substrate side in the production process was a measurement surface.

"Measurement limit or less" in Table 2 indicates the state that water permeates and the contact angle cannot be measured.

**TABLE 1**

| | | | Example 1 | Example 2 | Example 3 | Example 4 | Comp. Ex. 1 | Comp. Ex. 2 | Comp. Ex. 3 | Comp. Ex. 4 |
|---|---|---|---|---|---|---|---|---|---|---|
| Intermediate layer and catalyst layer formation process | Amount of Fe thin film (ng/cm²) | | 260 | 260 | 550 | 550 | 550 | 550 | 550 | 550 |
| Catalyst atomization process | Heating temperature (°C) | | 865 | 865 | 865 | 765 | None | | | |
| | Heating time (min) | | 120 | 30 | 30 | 30 | | | | |
| | of Fe fine particle (numbers/µm²) | | 500 | 567 | 583 | 917 | 1050 | 1050 | 1050 | 1050 |
| CNT growth process | Composition of mixed gas (vol%) | H₂ | 65 | 65 | 65 | 65 | 43 | 43 | 32 | 65 |
| | | H₂O | 0.10 | 0.10 | 0.10 | 0.10 | 0.08 | 0.03 | 0.10 | 0.10 |
| | | C₂H₄ | 8 | 8 | 8 | 8 | 8 | 8 | 8 | 19 |
| Evaluation | Thickness (nm) | | 0.5 | 0.7 | 0.7 | 1.0 | 1.0 | 1.0 | 1.0 | 1.2 |
| | Degree of orientation | Middle part | 40.0 | 73.5 | 79.8 | 79.4 | 84.4 | 84.0 | 86.5 | 88.0 |
| | | Surface part | 30.0 | 32.0 | 46.9 | 56.9 | 41.9 | 61.9 | 38.8 | 58.3 |
| | Grip force | µ@23°C | 57 | 57 | 29 | 7.1 | 3.5 | 2.1 | 1.7 | 1.3 |
| | | µ@300°C | A | A | B | C | D | D | D | D |

**TABLE 2**

| | | | Example 1 | Example 2 | Example 3 | Example 4 | Comparative Example 5 |
|---|---|---|---|---|---|---|---|
| Intermediate layer and catalyst layer formation process | Amount of Fe thin film (ng/cm²) | | 260 | 260 | 550 | 550 | 550 |
| Catalyst atomization process | Heating temperature (°C) | | 865 | 865 | 865 | 765 | 865 |
| | Heating time (min) | | 120 | 30 | 30 | 30 | 30 |
| | Density of Fe fine particle (numbers/µm² ) | | 500 | 567 | 583 | 917 | 583 |
| CNT growth process | Composition of Mixed gas (vol%) | H₂ | 65 | 65 | 65 | 65 | 65 |
| | | H₂O | 0.10 | 0.10 | 0.10 | 0.10 | 0.10 |
| | | C₂H₄ | 8 | 8 | 8 | 8 | 8 |
| Compression after CNT growth | | | None | | | | Done |
| Evaluation | Thickness (nm) | | 0.5 | 0.7 | 0.7 | 1.0 | 0.2 |
| | Degree of orientation | Middle part | 40.0 | 73.5 | 79.8 | 79.4 | 13.4 |
| | | Surface part | 30.0 | 32.0 | 46.9 | 56.9 | 0.0 |
| | Density | Middle part | 34.0 | 43.0 | 42.7 | 33.8 | 46.7 |
| | | Surface part | 32.0 | 34.7 | 37.8 | 35.8 | 48.2 |
| | Contact angle to water (°) | | 137 | 134 | 138 | 127 | Measurement limit or less |
| | Grip force | µ@23°C | 57 | 57 | 29 | 7.1 | 1.8 |
| | | µ@300°C | A | A | B | C | D |

Although the present invention has been described in detail and by reference to the specific embodiments, it is apparent to one skilled in the art that various modifications or changes can be made without departing the spirit and scope of the present invention. This application is based on Japanese Patent Application No. 2018-18910 filed February 6, 2018, and the whole is applied herein by reference. Furthermore, all references cited herein are incorporated herein in their entities.

### REFERENCE SIGNS LIST

1: Carbon nanotube aggregate
2: Middle part
11, 12: Surface part

## Claims

1. A carbon nanotube aggregate comprising a plurality of carbon nanotubes aggregated in a sheet form, wherein a degree of orientation in a middle part is less than 84%, and a degree of orientation in at least one surface part is 15% or more.

2. The carbon nanotube aggregate according to claim 1, wherein the degree of orientation in at least one surface part is less than 50%.

3. The carbon nanotube aggregate according to claim 1 or 2, which has a thickness of 300 to 2000 µm.

4. The carbon nanotube aggregate according to any one of claims 1 to 3, wherein at least one surface thereof has a maximum static friction coefficient at 23°C with respect to a silicon wafer of 4 or more.

5. The carbon nanotube aggregate according to any one of claims 1 to 4, wherein a density in at least one surface part is 45 or less.

6. The carbon nanotube aggregate according to any one of claims 1 to 5, wherein at least one surface thereof has a contact angle with respect to water of 100° or more.

7. A fixing jig for transportation, including the carbon nanotube aggregate according to any one of claims 1 to 6.
